# EUROPEAN PATENT APPLICATION

(11) **EP 4 734 708 A1**
(43) Date of publication of application: **29.04.2026**
(21) Application number: 25164784.8
(22) Date of filing: 19.03.2025
(51) Int. Cl.: H10F 30/223

(54) **PHOTODIODE AND MANUFACTURING METHOD THEREOF**

(30) Priority: 25.10.2024 TW 113140910
(71) Applicant: Taiwan-Asia Semiconductor Corporation, Hsinchu City 30078 (TW)
(72) Inventor: Lin, Chun-Chieh, 30078 Hsinchu City (TW); Lan, Shao-Ju, 30078 Hsinchu City (TW)
(74) Representative: Michalski Hüttermann & Partner Patentanwälte mbB

(57) **Abstract**

A photodiode and a manufacturing method thereof are provided. The photodiode (100) comprises a first conductive type semiconductor layer (110), an intrinsic layer (120) and a second conductive type semiconductor layer (130). The intrinsic layer (120) is disposed on the first conductive type semiconductor layer (110) and designed to generate a photocurrent in response to receiving a light of a specific wavelength. The second conductive type semiconductor layer (130) is disposed on a central region of the intrinsic layer for exposing an outer peripheral region of the intrinsic layer surrounding the central region. The resistivity of the intrinsic layer (120) ranges from 4000 to 6300 Ω-cm.

## Description

### CROSS-REFERENCES TO RELATED APPLICATIONS

This application claims the benefit of priority to Taiwanese Patent Application No. 113140910 filed on October 25, 2024, which is hereby incorporated by reference in its entirety.

### BACKGROUND OF THE INVENTION

### Field of the Invention

The present invention relates to a photodiode and a manufacturing method thereof, and in particular to a photodiode with high linearity for photodectection and a manufacturing method thereof.

### Descriptions of the Related Art

A photodiode is an electronic device designed to convert external optical signals into electrical signals. The core function of a photodiode lies in its ability to absorb external light for enabling the detection of optical signals and their conversion into measurable current. This conversion is critical for various applications, such as optical communication, optical measurement, and image generation.

The mechanism by which photodiodes absorb external light relies on the semiconductor materials within the diode (e.g., silicon substrate). When photons enter the photodiode and are absorbed, their energy excites electrons in the valence band to transition to the conduction band for generating electron-hole pairs. These photogenerated carriers are separated under the influence of the diode's built-in electric field and an electric current is generated correspondingly.

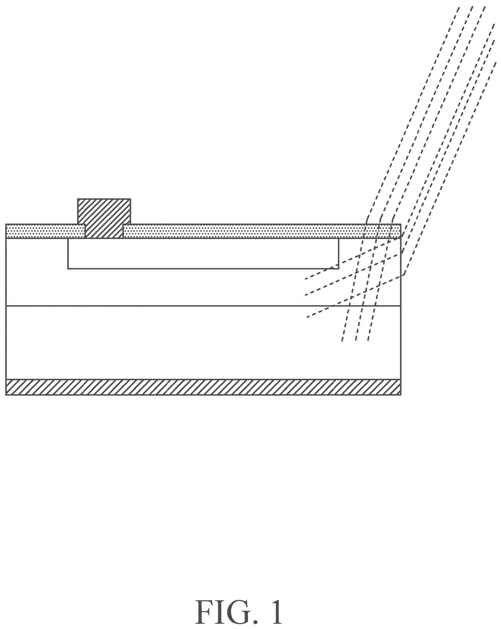

However, in practical applications of traditional photodiodes, external light can easily penetrate the exposed sidewalls of the device and lead to interference in internal operations. This interference degrades the linearity of the photodetector's performance and introduces computational errors in subsequent applications. As shown in FIG. 1, external light penetrating the exposed sidewalls of a conventional photodiode is concentrated at the edges of the device due to the refractive index (3.4) of the silicon substrate, which is significantly higher than the refractive index (1) of air. This phenomenon further affects the detection linearity of the photodiode.

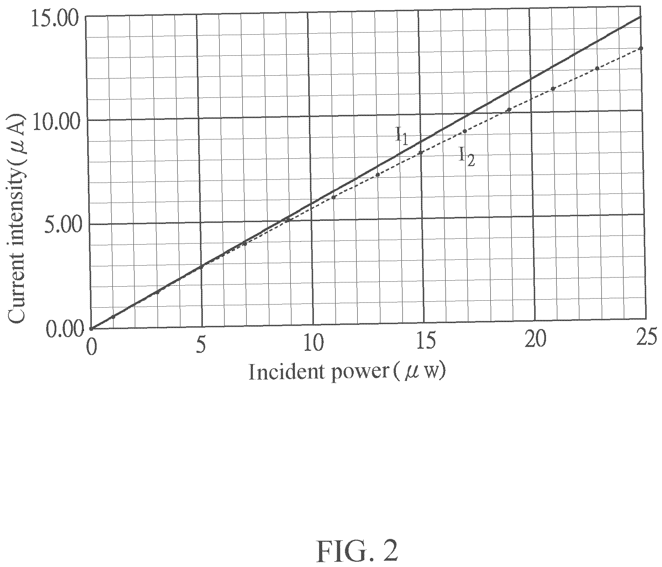

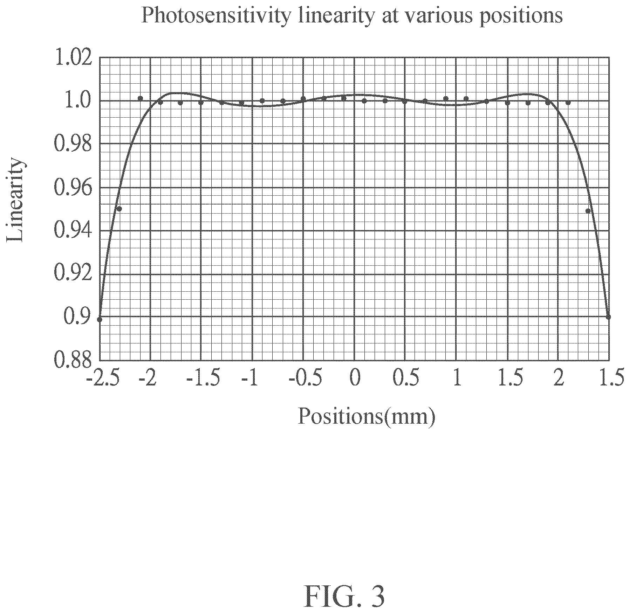

As illustrated in FIG. 2, line I₁ represents the photodiode's ideal linearity, wherein the current intensity generated by the photodiode maintains a linear relationship with the increasing power of incident external light. On the other hand, line I₂ represents the actual linearity between the incident light power and the corresponding current intensity under practical operating conditions. As shown in FIG. 2, as the incident power increases, the intensity of the electrical signal generated by the photodiode cannot maintain a linear growth relationship and exhibits a certain degree of attenuation. Additionally, as shown in FIG. 3, analyzing the linearity of the sensitivity across various positions within the photodiode reveals a stark contrast: the central region maintains high consistency in the linearity of its sensitivity, while the edge region experiences a sharp decline. To address these issues, there is an urgent need for an innovative photodiode structure to resolve the problem of inadequate linearity for its sensitivity caused by external light penetrating the device's sidewalls.

### SUMMARY OF THE INVENTION

The main objective of the present invention is to provide an innovative photodiode and its manufacturing method. Compared to conventional photodetector devices, the photodiode of the present invention reduces the doping concentration of dopants in the intrinsic layer for thereby substantially expanding the range of the depletion region in the intrinsic layer, improving the linearity of the detection of the photodiode, and increasing the computational correctness of device in subsequent applications.

To achieve the above objective, the present invention discloses a photodiode comprises a first conductive type semiconductor layer, an intrinsic layer and a second conductive type semiconductor layer. The intrinsic layer is disposed on the first conductive type semiconductor layer and designed to generate a photocurrent in response to receiving a light of a specific wavelength. The second conductive type semiconductor layer is disposed on a central region of the intrinsic layer for exposing an outer peripheral region of the intrinsic layer surrounding the central region. The resistivity of the intrinsic layers ranges from 4000 to 6300 Ω-cm.

In one embodiment of a photodiode of the present invention, a thickness of the intrinsic layer is 50 to 70 micrometers.

In one embodiment of a photodiode of the present invention, the intrinsic layer is an N type lightly doped epitaxial silicon layer.

In one embodiment of a photodiode of the present invention, the dopants of the intrinsic layer are selected from a group consisting of phosphorus (P), arsenic (As), and antimony (Sb).

In one embodiment of a photodiode of the present invention, the doping concentration of the dopants of the intrinsic layer is 7×10¹¹ to 1× 10¹² cm⁻³.

In one embodiment of a photodiode of the present invention, the second conductive type semiconductor layer is an N type heavily doped silicon layer with a thickness of 70 to 80 micrometers, doped with antimony (Sb) at a concentration of 10¹⁸~10¹⁹ cm⁻³.

To achieve the above objective, the present invention discloses a manufacturing method of a photodiode comprising the following steps: providing a first conductive type semiconductor layer; providing an intrinsic layer disposed on the first conductive type semiconductor layer and designed to generate a photocurrent in response to receiving a light of a specific wavelength; and providing a second conductive type semiconductor layer disposed on a central region of the intrinsic layer for exposing an outer peripheral region of the intrinsic layer surrounding the central region wherein the resistivity of the intrinsic layers ranges from 4000 to 6300 Ω-cm.

In one embodiment of a method of manufacturing a photodiode of the present invention, the step of providing an intrinsic layer is to provide an N type lightly doped epitaxial silicon layer with a thickness of 50 to 70 micrometers.

In one embodiment of a method of manufacturing a photodiode of the present invention, the step of providing an N type lightly doped epitaxial silicon layer is to provide an N type lightly doped epitaxial silicon layer with dopants selected from a group consisting of phosphorus (P), arsenic (As), and antimony (Sb).

In one embodiment of a method of manufacturing a photodiode of the present invention, the step of providing an N type lightly doped epitaxial silicon layer is to provide an N type lightly doped epitaxial silicon layer at a doping concentration of 7×10¹¹ to 1×10¹² cm⁻³.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1 is a schematic diagram illustrating the concentration of light after external light enters a conventional photodiode structure.
FIG. 2 is a schematic diagram showing the detection linearity of a conventional photodiode under ideal conditions and practical operation.
FIG. 3 is a schematic diagram illustrating the detection linearity across different positions within a conventional photodiode.
FIG. 4 is a schematic diagram of a photodiode in an embodiment of the present invention.
FIG. 5 is a schematic diagram showing the process steps of manufacturing a photodiode in an embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

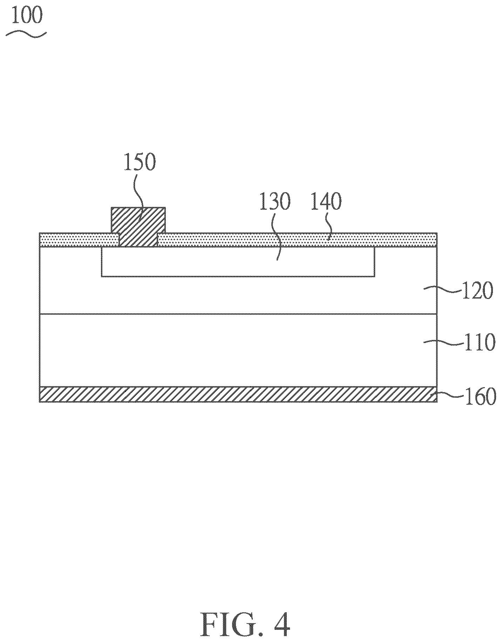

Please refer to FIG. 4, which illustrates a schematic diagram of a photodiode according to an embodiment of the present invention. In this embodiment, the photodiode 100 comprises a first conductivity type semiconductor layer 110, an intrinsic layer 120, a second conductivity type semiconductor layer 130, a protective layer 140, an upper electrode 150, and a lower electrode 160. The first conductivity type semiconductor layer 110 is an N type heavily doped semiconductor layer, such as, but not limited to, an antimony (Sb)-doped silicon wafer with a doping concentration of approximately 10¹⁸~10¹⁹ cm⁻³ and a thickness of about 70 to 80 micrometers (µm), but not limited thereto. The intrinsic layer 120 is a lightly doped epitaxial silicon semiconductor layer epitaxially grown on the first conductivity type semiconductor layer 110 designed to generate photocurrent in response to receiving light of a specific wavelength. The thickness of the intrinsic layer 120 is typically engineered to suit the wavelength and application requirements. Controlling the thickness of intrinsic layer 120 is crucial to photoelectric conversion efficiency. Taking the present invention as an example, the intrinsic layer 120 has a thickness of approximately, but not limited to, 50 to 70 micrometers (µm). Additionally, the second conductivity type semiconductor layer 130 is disposed on a central region of the intrinsic layer 120 for leaving an outer peripheral region of the intrinsic layer 120 exposed around the central region. The second conductivity type semiconductor layer 130 is a P type doped semiconductor layer, such as, but not limited to, a boron (B)-doped silicon layer with a doping concentration of 10¹⁹~10²⁰ cm⁻³.

The protective layer 140 is generally a band-pass filter layer covering the second conductivity type semiconductor layer 130. It selectively permits only light of a specific wavelength to pass through and be received by the intrinsic layer 120 while blocking other wavelengths, such as visible or infrared light. The protective layer 140 is typically composed of multiple stacked dielectric materials with alternating high and low refractive indices, such as silicon dioxide (SiO₂), titanium dioxide (TiO₂), or silicon nitride (Si₃N₄). In a preferred embodiment, the protective layer 140 further includes an anti-reflective layer formed on the band-pass filter layer for enhancing the transmittance of light at specific wavelengths, improving photon utilization efficiency, and minimizing reflection losses of incident light. Thereby, the photodiode's photoelectric conversion efficiency will increase accordingly. On the other hand, the upper electrode 150, serving as the anode electrode, is disposed on and electrically connected to the second conductivity type semiconductor layer 130. The lower electrode 160, serving as the cathode electrode, is disposed on the backside of the first conductivity -type semiconductor layer 110 and electrically connected to it. Both the upper electrode 150 and the lower electrode 160 may be made of, but are not limited to, aluminum metal.

As described above, the intrinsic layer 120 of the photodiode 100 in the present invention is an N type lightly doped epitaxial silicon layer. Specifically, to overcome the poor detection linearity issue of conventional photodiodes, the doping concentration of the intrinsic layer 120 is significantly reduced. The doping concentration of the intrinsic layer in the conventional photodiode, which typically ranges from 10¹²~10¹³ cm⁻³ (e.g., 2×10¹² to 4×10¹² cm⁻³), is lowered to a range of 7×10¹¹ to 1×10¹² cm⁻³ in the present invention. This adjustment increases the resistivity of the intrinsic layer 120 from the conventional range of 1000 to 2000 ohm-centimeters (Ω-cm) to 4000 to 6300 Ω-cm. According to the design theory of PIN (Positive-Intrinsic-Negative) photodiodes, reducing the dopant concentration and increasing the resistivity of the intrinsic layer 120 expands the depletion region. This electrical adjustment to the intrinsic layer enhances the linearity of the device's detection and addresses the poor linearity observed in the edge regions of conventional devices. As a result, the final devices incorporating the photodiode of the present invention exhibit significantly improved computational accuracy in subsequent applications. In specific embodiments, the dopants for the intrinsic layer 120 in the photodiode of the present invention are selected from the group consisting of phosphorus (P), arsenic (As), and antimony (Sb).

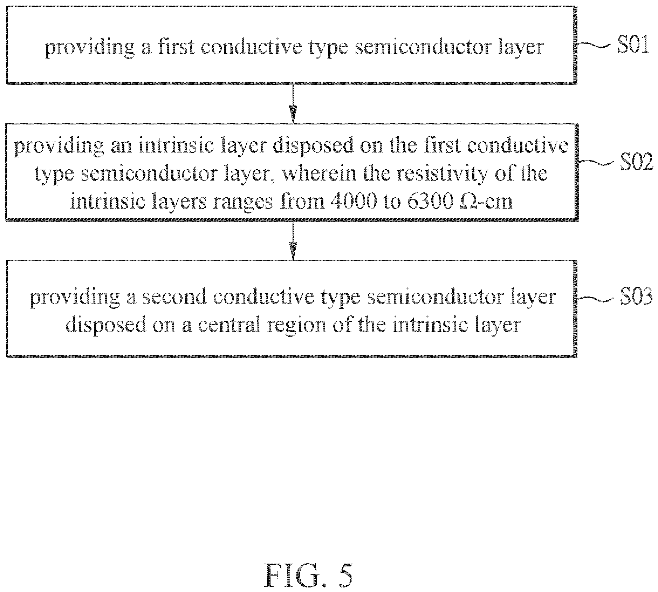

Please refer to FIG. 5, which illustrates the process steps for manufacturing the photodiode of the present invention. First, in step S01, a first conductivity type semiconductor layer is provided. Next, in step S02, an intrinsic layer is provided and deposited on the first conductivity type semiconductor layer. The intrinsic layer is designed to generate photocurrent in response to light of a specific wavelength. During this step, the resistivity of the intrinsic layer is increased from the conventional range of 1000 to 2000 Ω-cm to a range of 4000 to 6300 Ω-cm. Finally, in step S03, a second conductivity type semiconductor layer is provided and disposed on a central region of the intrinsic layer while leaving an outer peripheral region of the intrinsic layer exposed. Descriptions of the related components may be referenced from the content above and are not repeated here for brevity.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A photodiode, comprising:
a first conductive type semiconductor layer;
an intrinsic layer, disposed on the first conductive type semiconductor layer and designed to generate a photocurrent in response to receiving a light of a specific wavelength; and
a second conductive type semiconductor layer, disposed on a central region of the intrinsic layer for exposing an outer peripheral region of the intrinsic layer surrounding the central region,
wherein the resistivity of the intrinsic layers ranges from 4000 to 6300 Ω-cm.

2. The photodiode of claim 1, wherein a thickness of the intrinsic layer is 50 to 70 micrometers.

3. The photodiode of claim 1, wherein the intrinsic layer is an N type lightly doped epitaxial silicon layer.

4. The photodiode of claim 3 wherein the dopants of the intrinsic layer are selected from a group consisting of phosphorus (P), arsenic (As), and antimony (Sb).

5. The photodiode of claim 4, wherein the doping concentration of the dopants of the intrinsic layer is 7×10¹¹ to 1×10¹² cm⁻³.

6. The photodiode of claim 1, wherein the second conductive type semiconductor layer is an N type heavily doped silicon layer with a thickness of 70 to 80 micrometers, doped with antimony (Sb) at a concentration of 10¹⁸~10¹⁹ cm⁻³.

7. A manufacturing method of a photodiode, comprising:
providing a first conductive type semiconductor layer;
providing an intrinsic layer, disposed on the first conductive type semiconductor layer and designed to generate a photocurrent in response to receiving a light of a specific wavelength; and
providing a second conductive type semiconductor layer, disposed on a central region of the intrinsic layer for exposing an outer peripheral region of the intrinsic layer surrounding the central region,
wherein the resistivity of the intrinsic layers ranges from 4000 to 6300 Ω-cm.

8. The manufacturing method of a photodiode of claim 7, wherein the step of providing an intrinsic layer is to provide an N type lightly doped epitaxial silicon layer with a thickness of 50 to 70 micrometers.

9. The manufacturing method of a photodiode of claim 8, wherein the step of providing an N type lightly doped epitaxial silicon layer is to provide an N type lightly doped epitaxial silicon layer with dopants selected from a group consisting of phosphorus (P), arsenic (As), and antimony (Sb).

10. The manufacturing method of a photodiode of claim 9, wherein the step of providing an N type lightly doped epitaxial silicon layer is to provide an N type lightly doped epitaxial silicon layer at a doping concentration of 7×10¹¹ to 1×10¹² cm⁻³.

## Amended claims

### Amended claims in accordance with Rule 137(2) EPC.

1. A photodiode (100), comprising:
a first conductive type semiconductor layer (110);
a first conductive type lightly doped epitaxial silicon layer (120), disposed on the first conductive type semiconductor layer (110) and designed to generate a photocurrent in response to receiving a light of a specific wavelength; and
a second conductive type semiconductor layer (130), disposed on a central region of the first conductive type lightly doped epitaxial silicon layer (120) for exposing an outer peripheral region of the first conductive type lightly doped epitaxial silicon layer (120) surrounding the central region, wherein
the doping concentration of the dopants of the first conductive type lightly doped epitaxial silicon layer (120) is 7× 10¹¹ to 1×10¹² cm⁻³ such that the resistivity of the first conductive type lightly doped epitaxial silicon layer (120) is in a range of 4000 to 6300 Ω-cm.

2. The photodiode of claim 1, wherein a thickness of the first conductive type lightly doped epitaxial silicon layer (120) is 50 to 70 micrometers.

3. The photodiode of claim 1 wherein the dopants of the first conductive type lightly doped epitaxial silicon (120) layer are selected from a group consisting of phosphorus (P), arsenic (As), and antimony (Sb).

4. The photodiode of claim 1, wherein the first conductive type semiconductor layer (110) is an N type heavily doped silicon layer with a thickness of 70 to 80 micrometers, doped with antimony (Sb) at a concentration of 10¹⁸~10¹⁹ cm⁻³.

5. A manufacturing method of a photodiode (100), comprising:
providing a first conductive type semiconductor layer (110);
providing a first conductive type lightly doped epitaxial silicon layer (120), disposed on the first conductive type semiconductor layer (110) and designed to generate a photocurrent in response to receiving a light of a specific wavelength; and
providing a second conductive type semiconductor layer (130) , disposed on a central region of the first conductive type lightly doped epitaxial silicon layer (120) for exposing an outer peripheral region of the first conductive type lightly doped epitaxial silicon layer (120) surrounding the central region, wherein
the doping concentration of the dopants of the first conductive type lightly doped epitaxial silicon layer (120) is 7×10¹¹ to 1×10¹² cm⁻³ such that the resistivity of the first conductive type lightly doped epitaxial silicon layer (120) is in a range of 4000 to 6300 Ω-cm.

6. The manufacturing method of a photodiode of claim 5, wherein the step of providing a first conductive type lightly doped epitaxial silicon layer (120) is to provide an N type lightly doped epitaxial silicon layer with a thickness of 50 to 70 micrometers.

7. The manufacturing method of a photodiode of claim 6, wherein the step of providing an N type lightly doped epitaxial silicon layer is to provide an N type lightly doped epitaxial silicon layer with dopants selected from a group consisting of phosphorus (P), arsenic (As), and antimony (Sb).
